# EUROPEAN PATENT APPLICATION

(11) **EP 2 762 898 A1**
(43) Date of publication of application: **06.08.2014**
(21) Application number: 12836832.1
(22) Date of filing: 16.08.2012
(51) Int. Cl.: G01R 1/067

(54) **METHOD FOR MANUFACTURING CONTACT PROBE**

(30) Priority: 26.09.2011 JP 2011209778
(71) Applicant: Sumitomo Electric Industries, Ltd., Osaka-shi, Osaka 541-0041 (JP)
(72) Inventor: CHIBA, Yukifumi, Osaka-shi, Osaka 554-0024 (JP); NITTA, Koji, Osaka-shi, Osaka 554-0024 (JP); TOKUDA, Takeshi, Osaka-shi, Osaka 555-0033 (JP)
(74) Representative: Boult Wade Tennant
(86) International application number: PCT/JP2012/070823
(87) International publication number: WO 2013/046985

(57) **Abstract**

A method for manufacturing a contact probe (10) includes: a lithography step of obtaining a resin mold by forming a pattern for the contact probe (10), a pattern for a tie bar (20) in a shape of a frame therearound, and a pattern for a coupling portion (30) coupling these two patterns, in a resist formed on a conductive substrate, by lithography; an electroforming step of forming a layer made of a metal material on the resin mold by electroforming to form a metal structure (1) in which the contact probe (10) is integral with the tie bar (20) at the coupling portion (30); a removal step of removing the resin mold and the conductive substrate; a plating step of forming a plating layer on a surface of the metal structure (1) by electroplating after the removal step; and a separation step of separating the contact probe (10) from the metal structure (1) after the plating step. Thereby, a method for manufacturing the contact probe (10) capable of readily forming a plating layer with a uniform thickness on its surface can be provided.

## Description

### TECHNICAL FIELD

The present invention relates to a method for manufacturing a contact probe forming a plating layer on its surface.

### BACKGROUND ART

Conventionally, a probe card having many contact probes has been used in an electrical inspection for an electronic component such as a semiconductor chip including an IC, an LSI, and the like, and a liquid crystal device including an LCD and the like. In the inspection, leading ends of the contact probes are brought into contact with electrode pads of the electronic component to collect various data from the electronic component.

In recent years, as electronic components are further miniaturized and integrated, electrode pads have been increasingly provided with a narrower pitch, and a fine contact probe corresponding to a pitch of, for example, 100 µm or less is required. As a method for manufacturing such a fine contact probe, manufacturing methods by a LIGA (Lithographie Galvanoformung Abformung) method as a combination of lithography and electroforming have been proposed (see Japanese Patent Laying-Open No. 2001-343397 (Patent Literature 1), Japanese Patent Laying-Open No. 2005-127952 (Patent Literature 2), and Japanese Patent Laying-Open No. 2008-128882 (Patent Literature 3)).

### CITATION LIST

### PATENT LITERATURE

PTL 1: Japanese Patent Laying-Open No. 2001-343397
PTL 2: Japanese Patent Laying-Open No. 2005-127952
PTL 3: Japanese Patent Laying-Open No. 2008-128882

### SUMMARY OF INVENTION

### TECHNICAL PROBLEM

Recently, there has been a demand for forming a plating layer of gold (Au), rhodium (Rh), or the like on a surface of a contact probe for the purpose of improving characteristics of the contact probe such as sliding properties and corrosion resistance. Conventionally, however, a suitable method for forming a plating layer with a uniform thickness on a surface of a contact probe has not been proposed.

In a conventional method for manufacturing a contact probe, in order to form a plating layer on its surface, electroplating may be performed by immersing each manufactured contact probe into a plating bath. With this method, however, current is concentrated on corner portions of the contact probe, which causes a so-called edge effect in which the plating layer becomes thicker at the corner portions. Therefore, it is difficult to form a plating layer with a uniform thickness all over the surface.

Further, it is also conceivable to provide a tie bar around a contact probe and use it as a dummy cathode in forming a plating layer, as an improved measure for reducing the edge effect. However, it is difficult to provide the tie bar relative to the fine contact probe. Even if the tie bar can be provided, it is difficult to adjust the position of the tie bar relative to the contact probe with high accuracy, and its effect as a dummy cathode which uniformizes current distribution cannot be expected. Therefore, it is difficult to reduce variations in the thickness of the plating layer.

The present invention has been made in view of the above circumstances, and one object of the present invention is to provide a method for manufacturing a contact probe capable of readily forming a plating layer with a uniform thickness on its surface.

### SOLUTION TO PROBLEM

The present invention solves the aforementioned problem by forming a metal structure in which a contact probe is integral with a tie bar at a coupling portion, by the LIGA method, forming a plating layer on a surface of the metal structure, and thereafter separating the contact probe from the metal structure.

A method for manufacturing a contact probe in the present invention is characterized by including:
(1) a lithography step of obtaining a resin mold by forming a pattern for the contact probe, a pattern for a tie bar in a shape of a frame therearound, and a pattern for a coupling portion coupling these two patterns, in a resist formed on a conductive substrate, by lithography;
(2) an electroforming step of forming a layer made of a metal material on the resin mold by electroforming to form a metal structure in which the contact probe is integral with the tie bar at the coupling portion;
(3) a removal step of removing the resin mold and the conductive substrate;
(4) a plating step of forming a plating layer on a surface of the metal structure by electroplating after the removal step; and
(5) a separation step of separating the contact probe from the metal structure after the plating step.

With this configuration, by forming the metal structure in which the contact probe is integral with the tie bar at the coupling portion, and forming the plating layer thereon, the tie bar can be used as a dummy cathode. This can suppress current from being concentrated on corner portions of the contact probe, and uniformize current distribution. Further, since the tie bar is integrally formed around the contact probe via the coupling portion by the LIGA method, the tie bar can be arranged relative to the contact probe with a predetermined space therebetween, and thus the tie bar can be positioned at a predetermined position. Therefore, thickening of the plating layer at the corner portions of the contact probe can be suppressed, variations in the thickness of the plating layer can be reduced, and a plating layer with a uniform thickness can be formed all over a surface of the contact probe.

As one aspect of the manufacturing method in the present invention, the method includes a polishing step of polishing the surface of the metal structure before the planting step.

With this configuration, by including the polishing step of polishing the surface of the metal structure, the contact probe can be adjusted to have a predetermined thickness. Further, since polishing is performed with the tie bar being formed around the contact probe, the tie bar serves as a support during polishing, and polishing can be performed while uniformly exerting a force on the surface of the contact probe, which can prevent occurrence of unsymmetrical wear in the contact probe. In contrast, when polishing is performed by a method for polishing each contact probe in a conventional manner, a force is likely to be exerted on corner portions of the contact probe when compared with a central portion thereof, and it is difficult to uniformly exert a force on the surface of the contact probe. Therefore, unsymmetrical wear is likely to occur at the corner portions of the contact probe.

As one aspect of the manufacturing method in the present invention, the pattern for the contact probe, the pattern for the tie bar in the shape of the frame therearound, and the pattern for the coupling portion coupling these two patterns constitute a basic pattern, and a plurality of the basic patterns are continuously formed in one resist in the lithography step.

With this configuration, by forming the plurality of the basic patterns in one resist, a metal structure having a plurality of contact probes can be formed. Therefore, the manufacturing method can manufacture the plurality of contact probes at once, and is excellent in mass productivity.

### ADVANTAGEOUS EFFECTS OF INVENTION

The method for manufacturing the contact probe in the present invention can readily form a plating layer with a uniform thickness on a surface of a contact probe, by forming a metal structure in which the contact probe is integral with a tie bar at a coupling portion, and forming the plating layer thereon.

### BRIEF DESCRIPTION OF DRAWINGS

Fig. 1 is a schematic plan view illustrating a metal structure in accordance with Example 1.
Fig. 2 is a schematic enlarged fragmentary plan view of the metal structure shown in Fig. 1.
Fig. 3 illustrates a contact probe in accordance with Example 1, in which Fig. 3(A) is a schematic plan view and Fig. 3(B) is a schematic side view.

### DESCRIPTION OF EMBODIMENTS

A method for manufacturing a contact probe in the present invention includes a lithography step, an electroforming step, a removal step, a plating step, and a separation step as described below. Although the method for manufacturing the contact probe in the present invention is the same as conventional manufacturing methods in terms of adopting the LIGA method, it is different in term of forming a metal structure in which the contact probe is integral with a tie bar at a coupling portion. Hereinafter, each step in the method for manufacturing the contact probe in the present invention will be described.

The lithography step obtains a resin mold by forming a pattern for the contact probe, a pattern for the tie bar in the shape of a frame therearound, and a pattern for the coupling portion coupling these two patterns, in a resist formed on a conductive substrate, by lithography. As the conductive substrate, for example, a metal substrate made of copper (Cu), nickel (Ni), stainless steel, or the like can be used. Further, a silicon substrate sputtered with a metal such as titanium (Ti) or chromium (Cr), or the like can also be used. As the resist, a resin mainly composed of polymethacrylic acid ester such as polymethylmethacrylate (PMMA), or a chemically-amplified resin sensitive to ultraviolet (UV) rays or X rays can be used. The thickness of the resist may be arbitrarily set in accordance with the thickness of the metal structure (contact probe) to be formed, and is set, for example, to about 40 µm to 500 µm.

A mask having a predetermined pattern is arranged on the resist formed on the conductive substrate, UV or X rays are applied through the mask to form the predetermined pattern in the resist, and thereby the resin mold is obtained. Here, the predetermined pattern refers to a pattern corresponding to the shape of the metal structure to be formed, and specifically, the pattern for the contact probe, the pattern for the tie bar in the shape of a frame therearound, and the pattern for the coupling portion coupling these two patterns are formed. When a metal structure having a thickness of more than 100 µm and a high aspect ratio is formed, or when a metal structure with a high accuracy of about ± 2 µm is formed, it is preferable to use X rays (wavelength: 0.4 nm) having a wavelength shorter than that of UV rays (wavelength: 200 nm). It is more preferable to use X rays of synchrotron radiation (SR) having high directivity, among X rays. By the LIGA method, which uses SR X rays, deep lithography can be performed, and a metal structure with a thickness of several hundred micrometers can be formed with high accuracy of micron order. On the other hand, an advantage in term of cost can be pursued by using UV rays.

The pattern corresponding to the shape of the metal structure is formed in the mask, and the mask includes an absorption layer for UV or X rays or the like, and a light-transmitting base material. As the light-transmitting base material, silicon nitride (SiN), silicon (Si), diamond, titanium (Ti), or the like can be used in the case of the mask for X rays, and quartz glass or the like can be used in the case of the mask for UV rays. As the absorption layer, a heavy metal such as gold (Au), tungsten (W), or tantalum (Ta), a compound thereof, or the like can be used in the case of the mask for X rays, and chromium (Cr) or the like can be used in the case of the mask for UV rays. When a positive type resist is used, since an exposed portion of the resist is transformed by application of UV or X rays, the exposed portion is removed by development and an unexposed portion remains, and thus the resin mold is obtained. On the other hand, When a negative type resist is used, an exposed portion remains and an unexposed portion is removed in an opposite manner, and thus a pattern opposite to that in the case of the positive type resist is formed in the mask.

The electroforming step forms a layer made of a metal material on the resin mold by electroforming to form the metal structure in which the contact probe is integral with the tie bar at the coupling portion. As the metal material, for example, nickel (Ni) or a nickel alloy can be used. As the nickel alloy, a nickel-manganese (Ni-Mn) alloy, a nickel-iron (Ni-Fe) alloy, a nickel-cobalt (Ni-Co) alloy, a nickel-tungsten (Ni-W) alloy, a nickel-palladium (Ni-Pd) alloy, or the like can be used.

The removal step removes the resin mold and the conductive substrate. The resin mold can be removed, for example, by wet etching or plasma etching. The conductive substrate can be removed, for example, by wet etching with acid or alkali, or can be mechanically removed.

In addition, the method may include a polishing step of polishing a surface of the metal structure, as necessary, to adjust the contact probe to have a predetermined thickness. The polishing step may be performed before the plating step described below and before the removal step described above. The polishing step polishes a surface of the metal structure opposite to the conductive substrate.

The plating step forms a plating layer on the surface of the metal structure by electroplating after the removal step. The material for forming the plating layer can be selected as appropriate depending on the intended use and required characteristics, and rhodium (Rh), gold (Au), copper (Cu), or the like can be used. When the plating layer is formed of Rh, sliding properties of the contact probe can be improved. When the plating layer is formed of Au, corrosion resistance and solderability can be improved. When the plating layer is formed of Cu, conductivity can be improved. The thickness of the plating layer can also be determined depending on the intended use and required characteristics.

In the plating step, the metal structure is immersed into a plating bath to perform electroplating. On that occasion, the metal structure with a power-feeding jig attached thereto is arranged within a plating tank. Even if the metal structure is plated under the same conditions, a change in the position for arranging the metal structure within the plating tank may affect the thickness of the plating layer to be formed. Therefore, it is preferable to form a positioning portion such as a positioning hole or notch for attaching the above jig in the tie bar of the metal structure. Thereby, reproducibility of the position for arranging the metal structure can be ensured.

The separation step separates the contact probe from the metal structure after the plating step described above. Specifically, the contact probe is obtained by separating the contact probe from the metal structure by cutting the coupling portion.

### [Example]

Using the method for manufacturing the contact probe in the present invention described above, contact probes were manufactured, and variations in the thickness of a plating layer were evaluated.

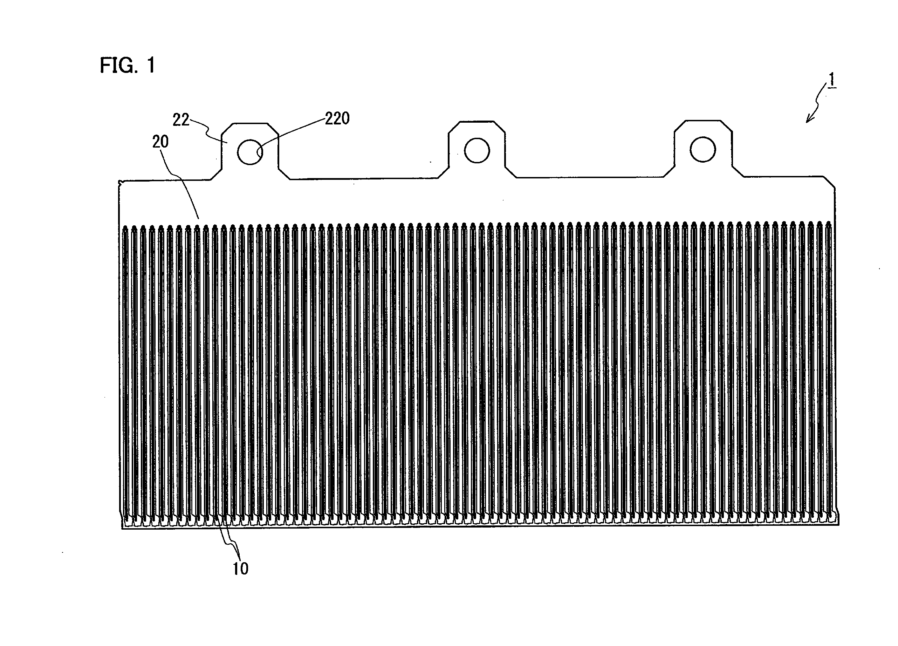

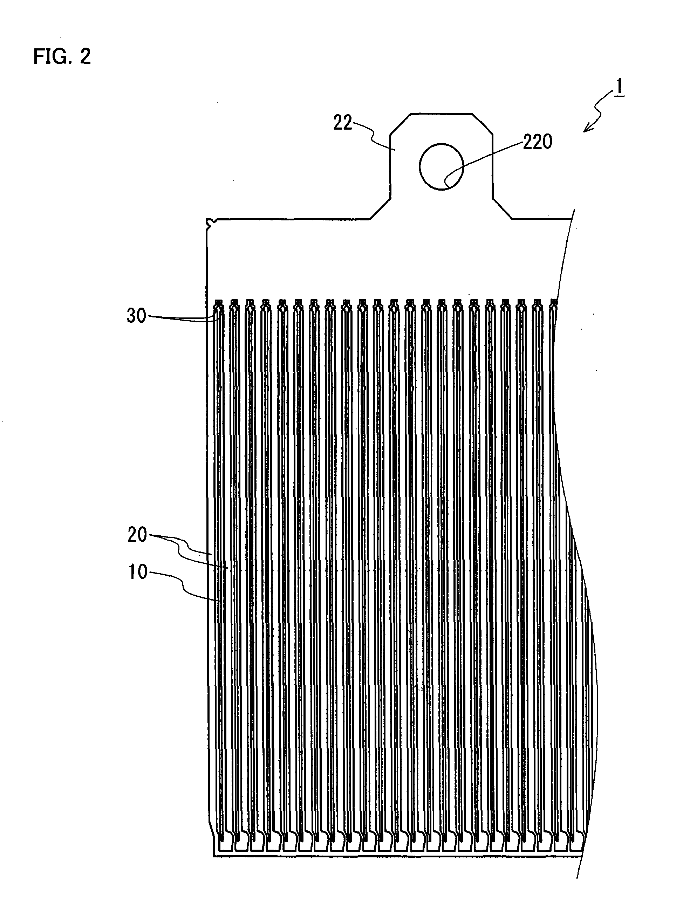

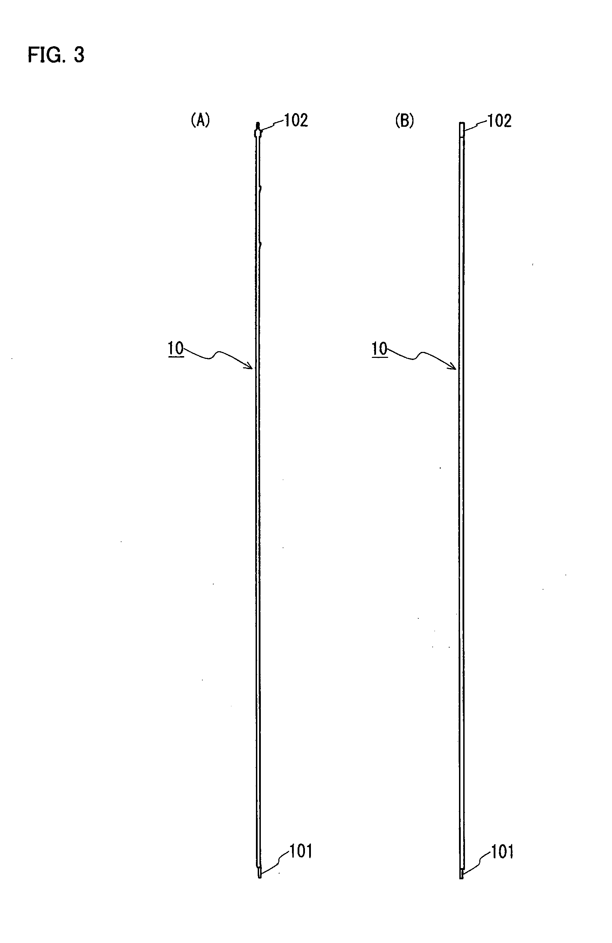

In this example, a metal structure 1 as shown in Figs. 1 and 2 was produced by the LIGA method to manufacture contact probes 10 in the shape shown in Fig. 3. As shown in Fig. 3, contact probe 10 is linear (length: about 8 mm, cross section: about 35x40 µm), and has a contact portion 101 for making contact with an electrode pad to be inspected, at one end (leading end), and a connection portion 102 to be connected to an inspection device, at the other end.

Metal structure 1 was formed as described below. A pattern for contact probe 10, a pattern for a tie bar 20 in the shape of a frame therearound, and a pattern for a coupling portion 30 coupling these two patterns constituted a basic pattern, and a plurality of the basic patterns were continuously formed in a resist formed on a conductive substrate in the lithography step, to obtain a resin mold (see Figs. 1 and 2). Then, in the electroforming step, a layer made of nickel was formed on the resin mold by electroforming to form metal structure 1 in which contact probe 10 was integral with tie bar 20 at coupling portion 30. In this example, 80 basic patterns were formed in one resist to form 80 contact probes 10 in metal structure 1.

Further, in metal structure 1, three rectangular protrusion pieces 22 were provided in tie bar 20 on an upper edge side, and an attachment hole 220 was formed in each protrusion piece 22. Protrusion pieces 22 each having attachment hole 220 were also formed by forming a pattern in the lithography step and simultaneously formed by electroforming.

Next, the resin mold and the conductive substrate were removed, and thereafter a surface of metal structure 1 was polished to adjust the thickness of contact probes 10.

Subsequently, metal structure 1 with a power-feeding jig attached to attachment holes 220 in tie bar 20 was arranged within a plating tank, and immersed in a commercially available rhodium plating bath to perform electroplating. Thereby, a rhodium plating layer was formed on the surface of metal structure 1. In this example, the target thickness of the plating layer was set to 0.5 µm. Further, by providing attachment holes 220 for the power-feeding jig in tie bar 20, attachment accuracy of the power-feeding jig is improved, and the position for arranging metal structure 1 relative to the plating tank can be determined accurately, which results in improved reproducibility.

After plating, metal structure 1 was taken out of the plating tank and cleaned, and then coupling portions 30 were cut to separate contact probes 10 from metal structure 1 (see Figs. 1 and 2). Thereby, a plurality of contact probes 10 (see Fig. 3) were obtained.

Arbitrary three contact probes were taken from among the plurality of contact probes obtained, and cross sections at three locations of the leading end of each contact probe were observed with a scanning electron microscope (SEM) to measure thickness distribution of the plating layer. Here, the thickness of the thinnest portion (minimum thickness) and the thickness of the thickest portion (maximum thickness) of the plating layer were measured in each of the cross sections (a total of nine cross sections) of the contact probes. As a result, in all measurements, the thickness distribution of the plating layer was within the range of 0.4 to 0.6 µm.

For comparison, a plurality of contact probes having the same shape as that in Example 1 were fabricated by the LIGA method, and a plating layer was formed on a surface of each contact probe by electroplating. The plating layer was formed as in Example 1, and the target thickness of the plating layer was set to 0.5 µm. Then, thickness distribution of the plating layer was measured as in Example 1. As a result, in all measurements, the plating layer became thicker at corner portions of each contact probe when compared with the other portions, and the thickness distribution of the plating layer was within the range of 0.2 to 1.2 µm.

From the results described above, it is found that, according to the method for manufacturing the contact probe in the present invention, variations in the thickness of the plating layer can be reduced, and the thickness distribution of the plating layer can be improved. That is, a plating layer with a uniform thickness can be readily formed on a surface of a contact probe.

It is noted that the present invention is not limited to the example described above, and can be modified as appropriate within the scope not departing from the gist of the present invention. For example, the material for and the shape of the contact probe (metal structure) may be modified as appropriate. Further, the material for and the thickness of the plating layer may be modified as appropriate.

### INDUSTRIAL APPLICABILITY

The method for manufacturing the contact probe in the present invention is suitably applicable to the manufacturing of a contact probe having a plating layer on its surface.

### REFERENCE SIGNS LIST

1: metal structure; 10: contact probe; 101: contact portion; 102: connection portion; 20: tie bar; 22: protrusion piece; 220: attachment hole; 30: coupling portion.

## Claims

1. A method for manufacturing a contact probe (10), comprising:
a lithography step of obtaining a resin mold by forming a pattern for the contact probe (10), a pattern for a tie bar (20) in a shape of a frame therearound, and a pattern for a coupling portion (30) coupling these two patterns, in a resist formed on a conductive substrate, by lithography;
an electroforming step of forming a layer made of a metal material on said resin mold by electroforming to form a metal structure (1) in which said contact probe (10) is integral with said tie bar (20) at said coupling portion (30);
a removal step of removing said resin mold and said conductive substrate;
a plating step of forming a plating layer on a surface of said metal structure (1) by electroplating after said removal step; and
a separation step of separating said contact probe (10) from said metal structure (1) after said plating step.

2. The method for manufacturing the contact probe (10) according to claim 1, comprising a polishing step of polishing the surface of said metal structure (1) before said plating step.

3. The method for manufacturing the contact probe (10) according to claim 1 or 2, wherein
the pattern for said contact probe (10), the pattern for said tie bar (20) in the shape of the frame therearound, and the pattern for said coupling portion (30) coupling these two patterns constitute a basic pattern, and
a plurality of said basic patterns are continuously formed in one said resist in said lithography step.

4. The method for manufacturing the contact probe (10) according to any of claims 1 to 3, wherein a positioning portion for attaching a power-feeding jig is formed in said tie bar (20).

5. The method for manufacturing the contact probe (10) according to any of claims 1 to 4, wherein said plating layer is any of rhodium, gold, and copper.
